Europäisches Patentamt

European Patent Office

Office européen des brevets

(19)

(11) Publication number: **0 036 907**
**B1**

(12) **EUROPEAN PATENT SPECIFICATION**

(45) Date of publication of patent specification: **10.04.85**

(21) Application number: **80107576.3**

(22) Date of filing: **04.12.80**

(51) Int. Cl.⁴: **H 01 L 23/12**, H 01 L 23/48 // H01L23/04

(54) **Multi-lead plug-in type package for circuit element.**

(30) Priority: **28.12.79 JP 171060/79**

(43) Date of publication of application:
**07.10.81 Bulletin 81/40**

(45) Publication of the grant of the patent:
**10.04.85 Bulletin 85/15**

(84) Designated Contracting States:
**DE FR GB NL**

(56) References cited:
**FR-A-1 517 770**
**US-A-3 532 944**

(73) Proprietor: FUJITSU LIMITED
1015, Kamikodanaka Nakahara-ku
Kawasaki-shi Kanagawa 211 (JP)

(72) Inventor: Tachibana, Kaoru
30-1, Enokigaoka Midori-ku
Yokohama-shi Kanagawa 227 (JP)

(74) Representative: Seeger, Wolfgang, Dipl.-Phys.
European Patent Attorney Bereiteranger 15
D-8000 München 90 (DE)

Courier Press, Leamington Spa, England.

EP 0 036 907 B1

# Description

The invention relates to a circuit device, and more particularly to a multi-lead plug-in type package for circuit element, comprising a substrate having thereon internal lead patterns or traces and a mounting surface, a circuit element or die secured on the mounting surface, the die being connected by wires to the internal lead patterns, the surface of the die or the wires projecting above the highest part of the substrate when the die is mounted.

The package for integrated circuits (IC) may be classified into two classes based on the kind of material used, that is, a plastic type and a ceramic type, and the present invention concerns the latter. The ceramic package in turn may be divided into three classes in accordance with the manner by which metal leads are formed, namely, a leadless type such as chip carrier, a flat pack type provided with leads extending horizontally from four sides of the pack, and a plug-in type. With one kind of the plug-in package a substrate of a conventional plug-in package has on its top surface a number of internal lead patterns or traces having holes at one end through which metal leads are inserted and brazed. A die or chip is mounted on the top surface of the substrate, and wires interconnect the bonding pads at end portions of traces opposite to holes and electrodes of the die. All of these processes are carried out in accordance with the known art.

The shown plug-in package may be modified by providing second series of lead-holes internally of the holes illustrated in the drawings in a concentric fashion, third series and so on.

There is also the dual in-line package (DIP) which has been the standard for electronic packaging for years, and it is of a generally rectangular shape, having two rows of leads arranged along its two longer sides.

One feature of these plug-in packages is that the surface on which a die or chip is mounted and the surface on which wire bonding is effected, that is the surface on which traces or internal lead patterns are formed are the same surface of substrate. Thus, when the die is mounted and wires are connected, the die or wires are taller than the highest part of the substrate. This kind of package is widely used in the industry because of ease, and consequently low cost of manufacture.

With the multi-layer ceramic package in which a die or chip is encased in a die cavity, special dies are required for manufacturing the ceramic substrate with a die cavity. The size of the die or chip varies from one application to another, and if dies must be changed to meet alteration of the size of a die cavity, manufacturing cost will become prohibitive.

This is the reason why the plug-in package, which requires no die cavity, is popular.

Such described circuit devices are not the finished product. Such packages are subject to subsequent handling. During such handling, it has been experienced that the wires or dies make physical contact with other objects, damaging either one or both of them. It has been revealed that such undesirable damage was mostly caused by toppling of the package during handling.

A plug-in type semiconductor according to the first paragraph of this specification is known from FR—A—1 517 770. This publication teaches a technology to produce semiconductor devices having three legs at the most.

The invention as claimed is intended to remedy these drawbacks experienced in the handling of unfinished plug-in type packages according to the prior art.

In one embodiment of the invention, projections taller than the mounted die or wires are provided to the package, and such projections are formed by metal leads to be placed at four corners of the package. The metal leads are so designed that, when these metal leads are inserted and secured in holes, the part or extension of each lead projecting above the top surface of the package is higher than the height of the wire or the die, whichever is the taller. By such a design, even if the package is inadvertently toppled, the wire and die are within the space defined by extensions of leads and protected against damage due to physical contact with the work floor or other object.

In another embodiment of the invention, at least one such projection is formed by a metal lead provided at a longer side of the package, preferably in the middle part thereof, or where one part of the package is heavier than another part, then at least one such lead is provided near to that part.

The above and further objects and novel features of the invention will appear more fully from the following detailed description when read in connection with the accompanying drawings. It is to be expressedly understood, however, that the drawings are not intended as a definition of the invention but are for the purpose of illustration only.

One way of carrying out the invention is described in detail below with reference to drawings which illustrate several specific embodiments:

Fig. 1 is a plan view of a plug-in package according to the conventional art;

Fig. 2 is a cross-sectional view taken along the line II—II of Fig. 1 and seen in the direction of arrows, showing the leads on the upper edge of the package shown in Fig. 1;

Fig. 3 is a plan view of a plug-in package according to the present invention;

Fig. 4 is a cross-sectional view taken along the line IV—IV of Fig. 3 and seen in the direction of arrows, showing the leads in the same manner as in Fig. 2 and

Fig. 5 is a partially cut-off picture view of another embodiment of the invention.

It is to be understood that all the packages shown in the drawings are half-finished products. For example, a resin must be coated and a cap must be mounted to the plug-in package of Fig. 3. And thus, these packages are subject to further handling such as transportation or removal to a next stage of operation.

As explained before, substrate 1 of a plug-in package is formed on the top surface with a number of internal lead patterns or traces 2. There is a hole 3 for metal lead 4 (Fig. 3) at an end of each trace 2 near an edge of the substrate 1, and each metal lead 4 is inserted into hole 3 brazed and plated. A die 5 is mounted on the surface of substrate 1 as shown, and wires 6 connect electrodes of die 5 to bonding pads at the ends of traces 2 opposite to the holes 3. When the die is mounted and the wires are connected, the die or wires are taller than the tallest part of the substrate. Structures of the kind just described are widely used because of ease of manufacture and low cost.

Internal lead patterns or traces are made using a screen and once the patterns are finalized, the same screen may be used repeatedly. The replacement of screens is not too expensive. There is only one substrate, and there is no need to form a die cavity. Since dies are required to make a die cavity, the substrate having a die cavity can be expensive. A substrate of the package of the invention is not so, since there is no need of a die cavity, and consequently no need for dies to make it.

As will be apparent, the die 5 and wires 6 are exposed since they are taller than the highest part of the substrate. If the package is toppled, for example, wires 6 and the die 5 will easily make physical contact with the floor on which the package is placed, because wires 6 are fine and are not strong enough to protect the die 5. Since the package must be transported to a next stage of operation, there is a danger that the package is toppled, or makes physical contact with another package or object, so that the die 5 and wires 6 are constantly exposed to the danger of being damaged.

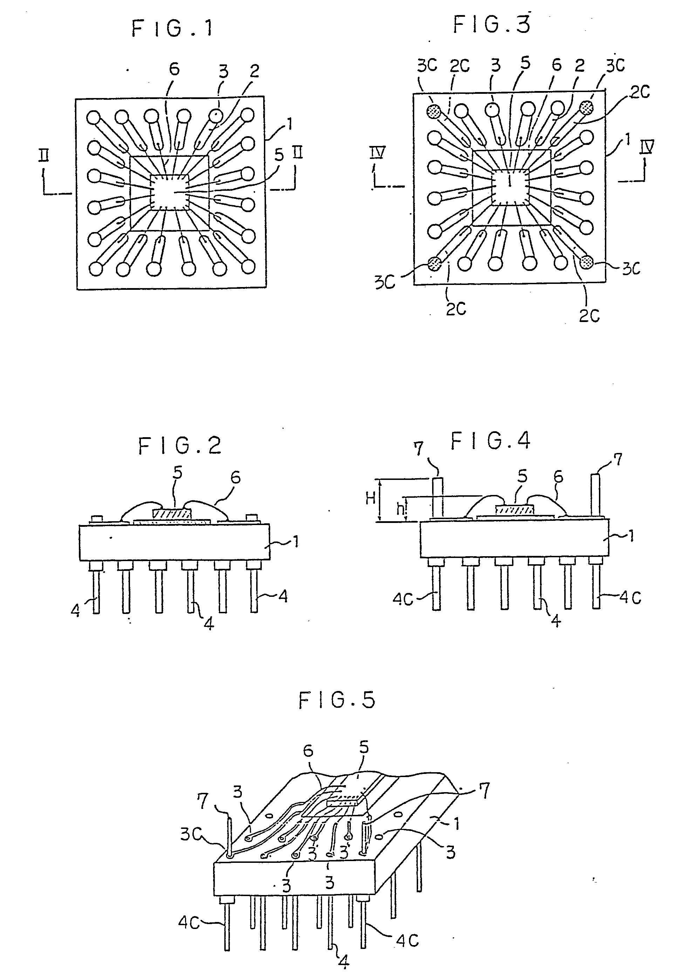

Fig. 3 is a plan view of a plug-in package according to the present invention, and Fig. 4 is a cross-sectional view taken along the line IV—IV of Fig. 3 and seen in the direction of arrows, showing six leads inserted into holes along the upper edge of the package as seen in Fig. 3. In the package, the substrate, internal lead patterns or traces, holes for metal leads, the die or chip and wires are the same as those shown in Fig. 1, so that the same reference numerals are used, except the traces 2C and hatched holes 3C for metal leads at four corners of the package and metal leads 4C designed according to the invention. The package is provided with projections 7 for protecting the die and wire according to the invention. The projections 7 are higher than the die or wires which in turn are taller than the highest part of the substrate. In the invention such projections 7 are provided by metal leads 4C. Metal leads 4C to be inserted and secured in holes 3C at four corners of the package are prepared with longer dimensions than other leads 4. Each lead 4C is so designed that when inserted and secured in hole 3C, length H of its extension projecting above the surface of the substrate 1 is at least twice as high as the height of the wire 6, assuming the uppermost part of the wire 6 is above the die 5 as seen in Fig. 4. In the shown embodiment, the height h is 0.8 mm and the height H 1.6 mm. The shown half-finished product is subsequently coated with resin, and a cap is placed on the substrate according to the known technology to offer a completed package.

By such a design, it was confirmed that even when the package is toppled, wires 6 and die 5 are secure within the space defined by projections or extensions 7 of four metal leads 4C.

It will be understood from the above description that the feature of the invention may also be applied to the conventional DIP, now shown. Metal leads or projections at four corners of the DIP may be so made that part of the metal lead extending upwardly from the surface of the package is higher than the uppermost part of the wire connecting the electrode of a die to a bonding pad, assuming the uppermost part of the wire is taller than the height of the die.

The feature of the invention may further be applied where holes for metal leads formed at one end of traces are arranged in a concentrical fashion as seen in Fig. 5. Even where traces and holes for metal leads are arranged as shown in Fig. 5, four metal leads 4C or projections 7, which have extensions above the surface of the substrate 1 of the package, protect wires 6 and the die as effectively as in other embodiments described so far.

It was found that, where one of four metal leads 4C or projections 7 of Fig. 4 is missing, the remaining three metal leads 4C protect the die and wires just as effectively as where there are four leads. Furthermore, where two upper leads 4C as seen in Fig. 4 are not provided, remaining or lower (as seen in Fig. 3) two leads 4C are also effective in providing a space in which the die 5 and wires 6 can be protected.

Upon experiments, it was further confirmed that where any one of the packages is provided with only one lead 4C or projection 7 according to the invention at one side of the package, preferably in the middle part thereof, such lead 4C serves the purpose of protecting the die on the surface of the substrate and wires connecting the die electrodes to bonding pads. It was found further that where one part of the package is heavier than other part of the package for some reason, lead 4C or projection 7 according to the invention which is placed near such heavy part protects the die and wires just as effectively as in other embodiments when the package is toppled. It will be apparent that where such a package is toppled, the heavier part will fall down first, and the lead 4C placed near such a part will support the package so that the die and wires will be safe in the space offered by the lead 4C.

It will be understood from the foregoing description that, in a circuit device or plug-in package according to the invention, die and wires exposed on the surface of substrate of the package are safely protected, during handling of the half-finished package, against damage due to physical contact with other object resulting from toppling of the package by providing at least one projection or metal lead which has an extension above the substrate approximately two times as high as the uppermost part of the wire which is higher than any part of the substrate, assuming the wire is above the die. If the die is higher than the wire, the extension of the lead is accordingly designed such that it is twice as tall as the die. Design and manufacture of such metal lead can be realized without special addition to the conventional processes. There is no need to add or attach any other means to protect the die and wires. Thus, the present invention serves the purpose of improving reliability of the IC package by preparing certain metal leads longer than others.

**Claims**

1. A multi-lead plug-in type package for circuit element, comprising a substrate (1) having thereon internal lead patterns or traces (2) and a mounting surface, a circuit element or die (5) secured on the mounting surface, the die being connected by wires (6) to the internal lead patterns (2), the surface of the die (5) or the wires (6) projecting above the highest part of the substrate (1) when the die (5) is mounted, the device further comprising metal leads (4) extending through the substrate and contacting the lead patterns or traces (2) of which leads a relatively small number projects above the die or wires so as to protect the die or wires during handling of the package.

2. A circuit device of claim 1 wherein one projection (7) is provided by an extension of a metal lead (4) extending above the substrate (1).

3. A circuit device of claim 1 or 2 wherein the projection (7) is at least twice as tall as the uppermost part of the wires (6) or the die (5).

4. A circuit device of any of claims 1 to 3, wherein four projections (7) are provided at four corners of the substrate (1).

5. A circuit device of any of claims 1 to 4, wherein three projections (7) are provided.

6. A circuit device of claim 1, 2 or 3 wherein the projection (7) is provided at one longer side of the substrate (1).

7. A circuit device of claim 1, 2 or 3 wherein one such projection (7) is provided near a part of the package that is heavier than the other parts.

8. A circuit device of any of claims 1 to 3 wherein two projections (7) are provided.

9. A circuit device of claim 1 wherein a width of the device is longer than a height of the device.

**Revendications**

1. Boîtier du type enfichable à plusieurs éléments de connexion pour élément de circuit, comprenant un substrat (1) portant des configurations, ou tracés, (2) d'éléments de connexion internes et une surface de montage, un élément de circuit, ou puce, (5) fixé à la surface de montage, la puce étant connectée par des câbles (6) aux configurations (2) d'éléments de connexion internes, la surface de la puce (5) ou des câbles (6) faisant saillie au-dessus de la partie la plus haute du substrat (1) lorsque le puce (5) est montée, le dispositif comprenant en outre des éléments de connexion métalliques (4) qui traversent le substrat et sont en contact avec les configurations, ou tracés, (2) d'éléments de connexion, un nombre relativement petit des ces éléments de connexion faisant saillie au-dessus de la puce ou des câbles afin de protéger la puce ou les câbles lors de la manipulation du boîtier.

2. Dispositif pour circuit selon la revendication 1, où seule partie saillante (7) est formée par un prolongement d'un élément de connexion métallique (4) s'étendant au-dessus du substrat (1).

3. Dispositif pour circuit selon la revendication 1 ou 2, où la partie saillante (7) est au moins deux fois plus grande que la partie la plus haute des câbles (6) ou de la puce (5).

4. Dispositif pour circuit selon l'une quelconque des revendications 1 à 3, où quatre parties saillantes (7) sont disposées aux quatre coins du substrat (1).

5. Dispositif pour circuit selon l'une quelconque des revendications 1 à 4, où trois parties saillantes (7) sont prévues.

6. Dispositif pour circuit selon la revendication 1, 2 ou 3, où la partie saillante (7) est disposée sur un côté plus long du substrat (1).

7. Dispositif pour circuit selon la revendication 1, 2 ou 3, où une telle partie saillante (7) est disposée au voisinage d'une partie du boîtier qui est plus lourde que les autres parties.

8. Dispositif pour circuit selon l'une quelconque des revendications 1 à 3, où deux parties saillantes (7) sont prévues.

9. Dispositif pour circuit selon la revendication 1, où une largeur du dispositif est plus longue qu'une hauteur du dispositif.

**Patentansprüche**

1. Montagesockel vom Steckerstift-Typ für Schaltungselemente, mit einem Substrat (1), auf welchem interne Leitungsmuster oder Spuren (2) und eine Montageoberfläche vorgesehen sind, einem Schaltungselement oder Plättchen (5) welches an der Montageoberfläche befestigt ist und über Drähte (6) mit den inneren Leitungsmustern (2) verbunden ist, wobei die Oberfläche des Plättchens (5) oder der Drähte (6) über den höchsten Teil des Substrats (1) vorstehen, wenn das Plättchen (5) montiert ist, und mit Metalleitungen (4), die durch das Substrat vorstehen und die Leitungsmuster oder Spuren (2) berühren, von welchen Lietungen eine relativ kleine Anzahl oberhalb des Plättchens oder der Drähte vorsteht, um so das Plättchen oder die Drähte während der Handhabung des Montagesockels zu schützen.

2. Schaltungsvorrichtung nach Anspruch 1, bei welchem ein Vorsprung (7) durch eine Verlängerung einer oberhalb des Substrates (1) hinausstehenden Metall-Leitung (4) gebildet ist.

3. Schaltungsvorrichtung nach Anspruch 1 oder 2, bei welcher der Vorsprung (7) wenigstens zweimal so hoch wie der oberste Teil der Drähte (6) oder des Plättchens (5) ist.

4. Schaltungsvorrichtung nach einem der Ansprüche 1 bis 3, bei welcher vier Vorsprünge (7) an vier Ecken des Substrats (1) vorgesehen sind.

5. Schaltungsvorrichtung nach einem der Ansprüche 1 bis 4, bei welcher 3 Vorsprünge (7) vorgesehen sind.

6. Schaltungsvorrichtung nach Anspruch 1, 2 oder 3, bei welcher der Vorsprung (7) an einer längeren Seite des Substrats (1) vorgesehen ist.

7. Schaltungsvorrichtung nach Anspruch 1, 2 oder 3 bei welcher ein solcher Vorsprung (7) nahe einem Teil des Montagesockels, der schwerer als die anderen Teile ist, vorgesehen ist.

8. Schaltungsvorrichtung nach einem der Ansprüche 1 bis 3, bei welcher zwei Vorsprünge (7) vorgesehen sind.

9. Schaltungsvorrichtung nach Anspruch 1, bei welcher eine Breite der Vorrichtung länger als eine Höhe der Vorrichtung ist.

FIG.1

FIG.3

FIG.2

FIG.4

FIG.5